# EUROPÄISCHE PATENTSCHRIFT

(11) **EP 4 218 100 B1**
(45) Veröffentlichungstag und Bekanntmachung des Hinweises auf die Patenterteilung: **07.08.2024**
(21) Anmeldenummer: 21782928.2
(22) Anmeldetag: 22.09.2021
(51) Int. Cl.: H01R 9/26, H05K 7/14, G05B 19/042, G05B 19/05

(54) **FUNKTIONSMODUL ZUR STEUERUNG UND/ODER ÜBERWACHUNG TECHNISCHER PROZESSE**
FUNCTION MODULE FOR CONTROLLING AND/OR MONITORING TECHNICAL PROCESSES
MODULE FONCTIONNEL DE COMMANDE ET/OU DE SURVEILLANCE DE PROCESSUS TECHNIQUES

(30) Priorität: 25.09.2020 DE 102020125076
(43) Veröffentlichungstag der Anmeldung: 02.08.2023
(73) Patentinhaber: Weidmüller Interface GmbH & Co. KG, 32758 Detmold (DE)
(72) Erfinder: GURLT, Ingo, 33602 Bielefeld (DE); SCHUMACHER, Ralf, 32657 Lemgo (DE); SCHNATWINKEL, Michael, 32051 Herford (DE)
(74) Vertreter: Kleine, Hubertus
(86) Internationale Anmeldenummer: PCT/EP2021/076054
(87) Internationale Veröffentlichungsnummer: WO 2022/063821

(56) Entgegenhaltungen:
- EP-A2- 1 022 809
- DE-U1- 202011 000 834

## Beschreibung

Die Erfindung betrifft ein busfähiges und insbesondere auch netzwerkfähiges aneinanderreihbares Funktionsmodul nach dem Oberbegriff von Anspruch 1 zur Steuerung und/oder Überwachung technischer Prozesse, insbesondere in industriellen Automatisierungssystemen und/oder in industriellen loT (Internet of Things)-Systemen.

In industriellen Automatisierungssystemen, z.B. in Industrie 4.0 Systemen, und in industriellen loT-Systemen werden häufig Feldbusse und zunehmend auch eine äquivalente Funktion innehabende drahtgebundene Netze (z.B. Industrial Ethernet) oder Funknetze mit Kommunikationsschnittstellen zur Übertragung von Steuerungsdaten und/oder Messwerten zwischen einem zentralen und/oder mehreren dezentralen Steuerungsrechnern und Feldgeräten eingesetzt. Oft wird dabei nicht jedes einzelne Feldgerät unmittelbar an den Feldbus angeschlossen bzw. mit dem verdrahteten bzw. drahtlosen Netzwerk gekoppelt, sondern eine Ein- und Ausgabestation mit einer Mehrzahl von Ein- und Ausgabemodulen verwendet. Dabei wird ein sogenannter Feldbuskoppler, auch Kopfstation genannt, eingesetzt, der das Feldbusprotokoll auf ein meist proprietäres Protokoll eines Subbusses umsetzt und der es ermöglicht, die Mehrzahl der Ein- und Ausgabemodule über den Subbus mit dem Feldbus zu koppeln.

Ein- und Ausgabemodule (I/O-Module) sind in einer Vielzahl verschiedener Ausgestaltungen bekannt, beispielsweise als Module, die digitale und/oder analoge Ein- und/oder Ausgabekanäle bereitstellen (I/O-Module), oder Module, die als Signalwandler, Relaisbaustein, Zählerbausteine, Interface-Module usw. ausgebildet sind. Zusammengenommen stellt das System aus dem Feldbuskoppler und den angeschlossenen Modulen ein Beispiel der zuvor genannten Ein- und Ausgabestation dar.

Eine modulare Ein- und Ausgabestation kann in einer alternativen Ausgestaltung auch unmittelbar mit einem Steuerungsrechner als Kopfstation aufgebaut werden. In einem solchen Fall ist eine Ankopplung der Module unmittelbar an den Steuerungsrechner möglich.

Sowohl ein als Kopfstation ausgebildeter Feldbuskoppler, als auch ein als Steuerungsrechner ausgebildeter Feldbuskoppler und daran anschließbare Module stellen Funktionsmodule im Sinne der vorliegenden Anmeldung dar.

Im Hinblick auf eine physikalische Ausgestaltung einer modularen Ein- und Ausgabestation sind verschiedene Ausführungen bekannt. Ein flexibler Aufbau wird erreicht, wenn die Kopfstation und die anschließbaren Module als aneinanderreihbare Scheiben ausgebildet sind. Die Scheiben können untereinander mechanisch verbunden werden und/oder auf eine Hutschiene oder eine vergleichbare Tragschiene aufgesetzt sein. Die Kopfstation und die Module kontaktieren untereinander im aneinandergereihten Zustand, wobei über mehrere Module hinweg physikalisch und/oder logisch durchgehende Daten- und Stromversorgungsbusse gebildet werden. Ein Vorteil dieses Systems liegt neben der Flexibilität in einem kompakten und platzsparenden Aufbau, bei dem nur der Platzbedarf der tatsächlich benötigten Module anfällt.

Aneinanderreihbare Module für Steuerungssysteme sind z.B. aus der Druckschrift EP 1 022 809 A2 bekannt. Dabei sind an jedem Modul in einem Abschnitt Anschlüsse für Leiter angeordnet und in einem anderen Abschnitt Klemmen zur Aufnahme einer elektronischen Leiterkarte. Bei aneinandergereihten Modulen können dann nebeneinander liegende Klemmen verschiedener Module mittels aufgesetzter Stromschienen miteinander verbunden werden.

Eine weitere bekannte Ausgestaltung von aneinanderreihbaren Modulen ist beispielsweise in der Druckschrift DE 20 2011 000 834 U1 beschrieben. Die Module umfassen jeweils einen Sockel mit Rastmitteln zum Befestigen auf einer Tragschiene, wobei an dem Sockel seitlich in Anreihrichtung Busleiterkontakte angeordnet sind, um Module auf der Tragschiene aneinander zu reihen und einen Stromversorgungs- und/oder Datenbus aufzubauen, wodurch gegenüber dem System der Schrift EP 1 022 809 A2 der Einsatz externer Stromschienen entfällt.

Der Sockel ist dabei u-förmig aufgebaut und stellt eine nach oben offene Aufnahme mit einem Steckverbinder bereit, der mit den Busleiterkontakten verbunden ist. In den Steckverbinder kann von oben eine Leiterkarte eingesteckt werden, die mit einer ersten Kante den Steckverbinder kontaktiert und auf der eine Funktionselektronik des Moduls aufgebaut ist. Neben Gehäusedeckeln, die parallel zur Fläche der Leiterkarte ausgerichtet sind und die Leiterkarte seitlich abdecken, ist ein schwenkbar an dem Sockel angelenkter Anschlussrahmen vorhanden, der in einer zugeschwenkten Position die Leiterkarte entlang ihrer oberen Kante übergreift und der Einschubschächte für Anschlussmodule bereitgestellt. Die Anschlussmodule weisen an einer zugänglichen Oberseite Anschlüsse auf, über die das Modul mit einer Feldverdrahtung oder sonstigen Anschlussleitungen verbunden werden kann. Auf der gegenüberliegenden Unterseite ist ein Leiterkartenrandverbinder vorgesehen, der in einer zugeschwenkten Position des Anschlussrahmens auf die Leiterkarte aufgesteckt ist.

Das System erlaubt vorteilhaft durch Auswahl des geeigneten Anschlussmoduls, das Funktionsmodul an die benötigte Anschlussvariante anzupassen. Es können Anschlussmodule mit Anschlussarten, Anschlussgrößen und Anschlussanzahl, beispielsweise mit Push-In Anschlüssen, mit IDC (Insulation Displacement Connector)-Anschlüssen, mit Schraubanschlüssen, mit verschiedenen Steckkontakten usw. vorgesehen sein, die je nach Bedarf eingesetzt werden können. Ein weiterer Vorteil ist, dass nach Aufschwenken des Anschlussrahmens die Anschlussmodule mit verschwenkt und von der Leiterkarte gelöst werden. Eine defekte Leiterkarte kann ausgetauscht werden, ohne dass die Feldverdrahtung aufgebrochen und später erneut verbunden werden muss. Durch einfaches Wiederaufschwenken des Anschlussrahmens auf die getauschte Leiterkarte ist das Funktionsmodul unmittelbar wieder einsatzbereit.

Aus elektrischen Erwägungen und um eine hohe Bestückungsdichte zu erzielen ist der Einsatz des zusätzlichen Leiterkartenrandverbinders zwischen der Leiterkarte und dem Anschlussmodul jedoch nicht in allen Fällen gewünscht.

Es stellt sich daher für die vorliegende Erfindung die Aufgabe, ein Funktionsmodul der eingangs genannten Art zu schaffen, bei dem die Flexibilität in der Wahl der Anschlussmöglichkeit für Anschlüsse nach wie vor gegeben ist und gleichzeitig Anschlusselemente bereitgestellt werden, bei denen der zusätzliche Übergang zwischen der Leiterkarte und den Anschlusselementen entfällt.

Diese Aufgabe wird gelöst durch ein Funktionsmodul mit den Merkmalen des unabhängigen Anspruchs. Vorteilhafte Ausgestaltungen und Weiterbildungen sind Gegenstand der abhängigen Ansprüche.

Ein erfindungsgemäßes Funktionsmodul weist eine Montagebasis mit Rastmitteln zum Befestigen auf einer Tragschiene mit wenigstens einem seitlichen Busleiterkontakt auf, sowie einem Steckverbinder, der mit dem Busleiterkontakt verbunden ist. Es umfasst eine entlang einer ersten Kante in den Steckverbinder eingesteckte Leiterkarte, die an einer der ersten parallelen zweiten Kante Kontaktelemente aufweist, sowie einen schwenkbar an der Montagebasis angelenkten Anschlussrahmen, der in einer zugeschwenkten Position die Leiterkarte entlang ihrer zweiten Kante übergreift und der mindestens einen Einschubschacht bereitstellt. Mindestens ein Anschlussmodul ist in den mindestens einen Einschubschacht eingesetzt und stellt an einer zugänglichen Oberseite Anschlüsse bereit. An einer gegenüberliegenden Unterseite weist es einen Verbinder auf, der in einer zugeschwenkten Position des Anschlussrahmens auf die Leiterkarte aufgesteckt ist und deren Kontaktelemente kontaktiert.

Das Funktionsmodul zeichnet sich dadurch aus, dass die Leiterkarte entlang ihrer zweiten Kante gestuft ausgebildet ist, wodurch mindestens zwei Abschnitte gebildet sind, in denen die Leiterkarte unterschiedlich weit in Richtung des Anschlussrahmens ragt. Dabei befinden sich in einem ersten der Abschnitte Kontaktelemente zur Ankopplung eines Anschlussmoduls und in einem zweiten Abschnitt mindestens ein Anschlusselement, das durch eine Öffnung im Anschlussrahmen unmittelbar zugängig ist.

Das mindestens eine Anschlusselement kann entsprechend unmittelbar auf der Leiterkarte an deren zweiten Kante angeordnet sein. Diese Art der Kontaktierung des Anschlusselements mit der Leiterkarte eignet sich damit insbesondere für Anschlusselemente, die Signale oder Daten mit einer hohen Frequenz bzw. hohen Datenrate übertragen, insbesondere, aber nicht ausschließlich, um das Funktionsmodul netzwerkfähig zu machen. Die zusätzlich noch vorhandenen Anschlussmodule bieten für Signal-, Daten- oder Strom- bzw. Energieversorgungsanschlüsse die Möglichkeit einer flexiblen Kontaktierung der Leiterkarte, die durch Austauschen der Anschlussmodule an die gewünschte Anschlussart, Querschnittsgröße und Anschlussanzahl angepasst werden kann. Durch die gestufte Leiterkarte werden somit die Vorteile der flexibel austauschbaren Anschlussmodule mit der unmittelbaren Kontaktierung von Anschlusselementen auf der Leiterkarte kombiniert.

Als Funktionsmodule im Rahmen der Anmeldung, die zur Steuerung und/oder Überwachung technischer Prozesse dienen, sind z.B. I/O-Module einer Station von industriellen Automatisierungssystemen und/oder von industriellen IoT-Systemen ebenso zu verstehen wie Kopfmodule oder Erweiterungsmodulen zu den Kopfmodulen einer solchen Station. Dabei können als Kopfmodule und Erweiterungsmodule reine Protokollumsetzer, (komplexere) Kommunikationsknoten als Schaltzentrale im Netzwerk (mit Routing-, Netzwerkmanagement-, Netzwerkkonfigurations-, Parametrisierungs- und Protokollumsetzungs-Funktionen) und Rechenknoten angesehen werden. Weiter zählen auch (Hilfs-) Energieversorgungsmodule als anmeldungsgemäße Funktionsmodule.

Unter Protokollumsetzern sind z.B. Funkkoppler, Ethernetkoppler oder Feldbuskoppler, auch Gateway genannt, und loT / Edge-Gateways zu verstehen, als komplexere Kommunikationsknoten können Switches, Security-Router und (Mobilfunk-)Modems genannt werden, und Rechenknoten wie z.B. Steuerungsrechner (SPS) / Controller (PLC), Compact Controller SPS/PLC mit I/O-Schaltungen für den Anschluss von Sensoren und/oder Aktoren, loT-Terminal (der auch eine kompakte Kombination von Controller und I/O-Modulen darstellt), Safety Controller, Process Controller, Redundancy Controller, Motion Controller, Vision Controller, loT / Edge Controller (Computing) stellen Funktionsmodule mit einem Applikationsprogramm bereit. Unter I/O-Modulen sind Eingabe- und/oder Ausgabemodule für den Anschluss von Sensoren und/oder Aktoren zu verstehen, die an ein Kopfmodul oder eine Kopfstation angereiht werden. Als Energieversorgungsmodule sind z.B. Netzteile, USVs (unterbrechungsfreie Stromversorgungen), DC/DC-Wandler (Gleichspannungswandler) und elektronische Sicherungen zu nennen.

In einer vorteilhaften Ausgestaltung des Funktionsmoduls ist der Verbinder ein Leiterkartenrandverbinder, wobei die Kontaktelemente Leiterkartenrandkontakte sind, die entlang des Leiterkartenrands in dem ersten Abschnitt ausgebildet sind. So wird eine platzsparende und einfach umzusetzende elektrische Verbindung zwischen der Leiterkarte und den Anschlussmodulen geschaffen. Alternativ können die Kontaktelemente Kontakte eines Steckverbinders, insbesondere einer Buchsenleiste oder Stiftleiste, sein, der im Bereich des Leiterkartenrands in dem ersten Abschnitt angeordnet ist.

Anschlüsse der Anschlussmodule können dabei flexibel einzusetzende Einzelleiter-Anschlüsse sein, oder Push-In Anschlüsse, Schraubanschlüsse, IDC-Anschlüssen oder Steckverbinder mit verschiedenen Steckkontakt-Ausprägungen.

In einer weiteren vorteilhaften Ausgestaltung des Funktionsmoduls ist das mindestens eine Anschlusselement ein Steckverbinder, z.B. zur Datenübertragung, insbesondere ein USB-C und/oder RJ-45 und/oder Single-Pair Ethernet Steckverbinder. Weiter kann das mindestens eine Anschlusselement ein Schraubverbinder und/oder ein Steckverbinder für HF-Signale sein und/oder eine Aufnahme für eine steckbare Speicherkarte. Diese Elemente, die in der Regel für elektrische Signale mit hohen Frequenzen bzw. für Datensignale mit einem hohen Datendurchsatz geeignet sind, sind so vorteilhaft direkt auf der Leiterkarte montiert.

In einer weiteren vorteilhaften Ausgestaltung des Funktionsmoduls ist der Steckverbinder der Montagebasis ein Leiterkartenrandverbinder und die Leiterkarte weist an ihrer ersten Kante Leiterkartenrandkontakte auf. Auf diese Weise kann auf konstruktiv einfache Art und Weise eine mechanische Fixierung und elektrische Kontaktierung der Leiterkarte in der Montagebasis erfolgen. Andere Verbindungen sind alternativ ebenso denkbar.

In einer weiteren Ausgestaltung weist das Funktionsmodul mindestens zwei parallel zueinander angeordnete Leiterkarten auf, von denen mindestens eine mit einer ersten Kante in einen Steckverbinder der Montagebasis eingesteckt ist, und wobei mindestens eine der Leiterkarten gestuft ausgebildet ist. Das anmeldungsgemäße Konzept ist nicht somit nicht auf die Verwendung einer Leiterkarte in dem Funktionsmodul beschränkt, sondern kann auf mehrere parallele Leiterkarten übertragen werden, wobei nicht jede der Leiterkarten bis in die Montagebasis reichen muss (aber könnte) und auch nicht jede gestuft ausgebildet sein muss (aber könnte). Die parallelen Leiterkarten können mechanisch unabhängig voneinander in einem Gehäuse des Funktionsmoduls fixiert sein oder auch voneinander getragen werden, z.B. in Form einer parallel zu einer Leiterkarte angeordneten und von ihr getragenen Zusatzleiterkarte. Untereinander können die Leiterkarten zum Austausch von Energie und Signalen über einen Board-to-Board-Steckverbinder verbunden sein.

Eine zusätzliche Flexibilität kann erreicht werden, wenn die Anschlussmodule nicht unmittelbar mit der Leiterkarte in dem abgesenkten Bereich verbunden sind, sondern über mindestens ein dazwischen angeordnetes Steckmodul. Das Steckmodul kann z.B. elektronische Schaltungen zur Signalanpassung der über das Anschlussmodul ausgegebenen oder empfangenen Signale oder Daten aufweisen.

Die Erfindung wird nachfolgend anhand von Ausführungsbeispielen mit Hilfe von Figuren näher erläutert. Die Figuren zeigen:
- Fig. 1: ein erstes Ausführungsbeispiel eines Funktionsmoduls eines industriellen Automatisierungssystems in einer Draufsicht (links) und einer isometrischen Schrägansicht (rechts);
- Fig. 2: eine isometrische Ansicht des Funktionsmoduls gemäß Fig. 1 mit aufgeschwenktem Anschlussrahmen;
- Fig. 3: eine isometrische Ansicht des Funktionsmoduls gemäß Fig. 1 mit aufgeschwenktem Anschlussrahmen und entnommener Elektronikeinheit;
- Fig. 4: eine isometrische Explosionsdarstellung des Funktionsmoduls gemäß des ersten Ausführungsbeispiels;
- Fig. 5, 6: Ansichten analog zu den Fig. 1, 2 eines zweiten Ausführungsbeispiels eines Funktionsmoduls;
- Fig. 7a, b: Ansichten analog zu den Fig. 1, 2 eines dritten Ausführungsbeispiels eines Funktionsmoduls;
- Fig. 8: Ansichten analog zu Fig. 1 eines vierten Ausführungsbeispiels eines Funktionsmoduls; und
- Fig. 9a, b: Ansichten analog zu den Fig. 1, 2 eines fünften Ausführungsbeispiels eines Funktionsmoduls mit eingesetztem (Fig. 9a) bzw. abgenommenem Gehäusedeckel (Fig. 9b).

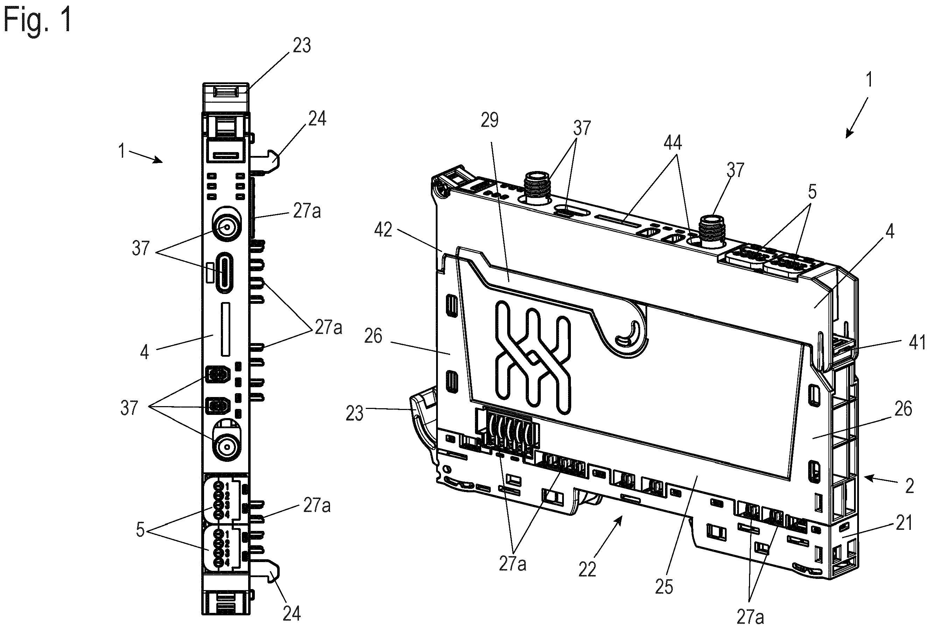

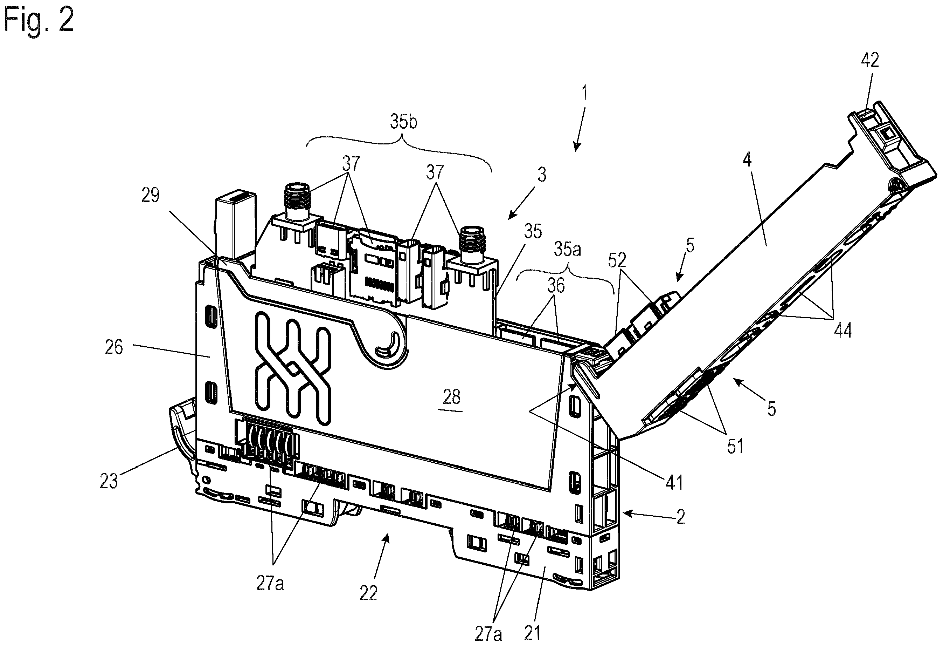

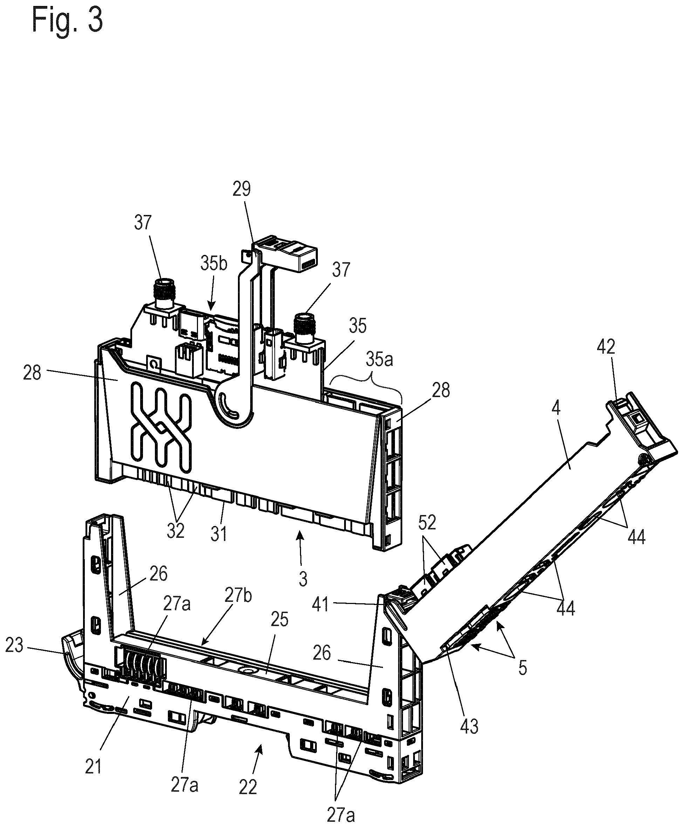

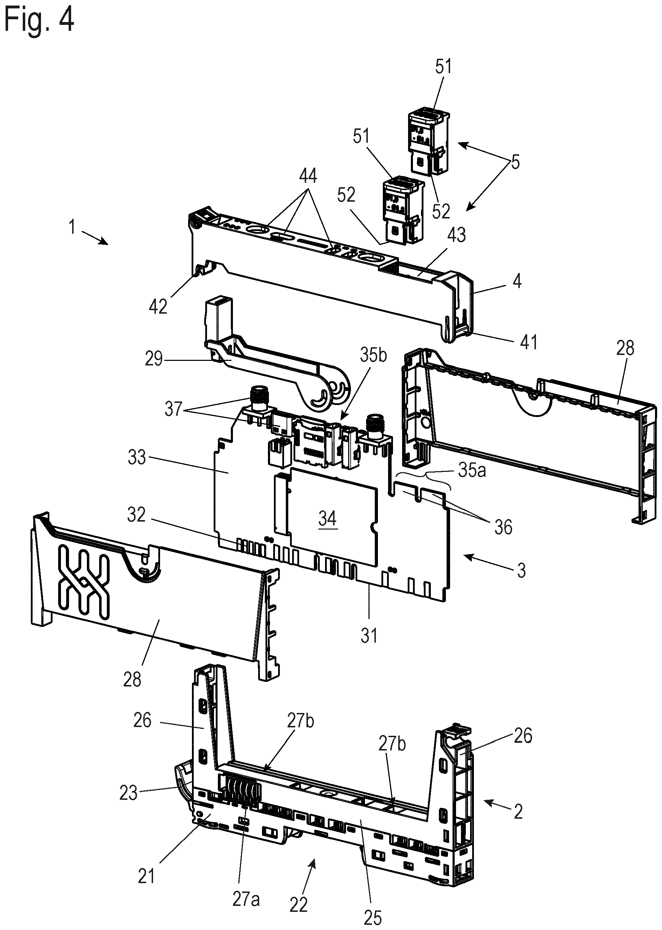

In den Fig. 1-3 ist ein erstes Ausführungsbeispiel eines Funktionsmoduls 1 in einer Draufsicht (Fig. 1 links) bzw. isometrischen Ansichten (Fig. 1 rechts, Fig. 2 und 3) in verschiedenen Montagezuständen gezeigt. Fig. 4 stellt das Funktionsmodul 1 dieses ersten Ausführungsbeispiels zudem in einer isometrischen Explosionszeichnung dar. Die nachfolgende Beschreibung bezieht sich auf das Funktionsmodul 1 der Fig. 1-4, wobei aus Gründen der Übersichtlichkeit nicht in jeder Figur jede Komponente mit einem Bezugszeichen versehen ist.

Das Funktionsmodul 1 weist eine Montagebasis 2 auf, die im Wesentlichen u-förmig ausgebildet ist. In einem mittleren und in den Figuren unteren Abschnitt der Montagebasis 2 ist ein Rastsockel 21 ausgebildet, der eine zentrale Tragschienenaufnahme 22 aufweist. Mit dieser Tragschienenaufnahme 22 kann die Montagebasis 2 und damit das gesamte Funktionsmodul 1 auf eine Tragschiene aufgerastet werden. Seitlich am Rastsockel 21 ist ein Lösehebel 23 ausgebildet, der bei Betätigung die Verbindung mit der Tragschiene löst und eine Entnahme des Funktionsmoduls 1 von der Tragschiene erlaubt.

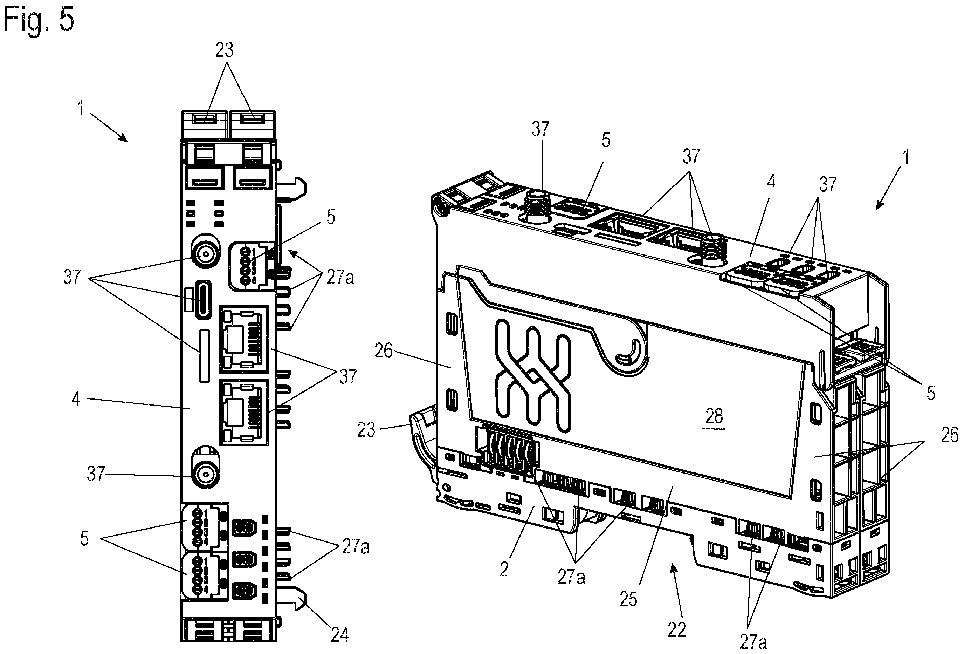

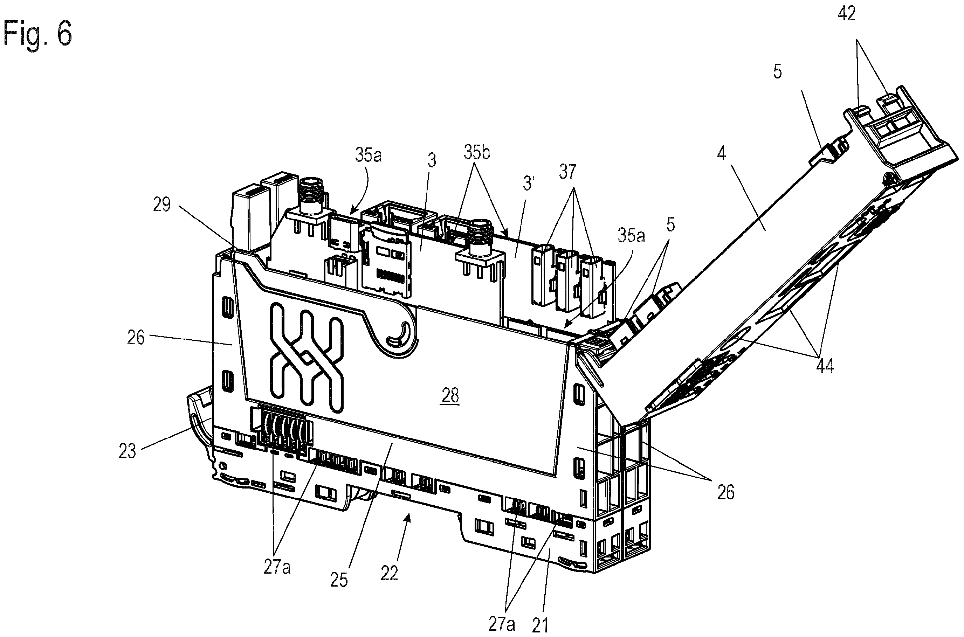

Auf dem Rastsockel 21 ist eine Gehäusebasis 25 angeordnet und bevorzugt durch Verrastung mit dem Rastsockel 21 verbunden, die seitlich vom Rastsockel 21 wegweisende Gehäuseseiten 26 aufweist. Die Gehäusebasis 25 mit den Gehäuseseiten 26 bildet eine u-förmige Aufnahme für eine Einheit aus Gehäusedeckeln 28 und Leiterkarte 3. Die Breite der Montagebasis 2 und damit des Funktionsmoduls 1, also die Erstreckung in Längsrichtung der Tragschiene, beträgt bei dem dargestellten Beispiel 11,5 Millimeter (mm). Diese Größe wird als eine Baueinheit bezeichnet. Es versteht sich, dass in abgewandelten Ausgestaltungen die Breite einer Baueinheit auch kleiner oder größer als die genannten 11,5 mm sein kann. In einem Funktionsmodul 1 der genannten Breite einer Baueinheit ist eine Leiterkarte 3 vorgesehen. Bei Funktionsmodulen 1 mit einer größeren Breite, wie beispielsweise im zweiten Ausführungsbeispiel im Zusammenhang mit den Fig. 5 und 6 nachfolgend vorgestellt, können auch mehr als die eine Leiterkarte angeordnet sein.

Außen an dem Rastsockel 21 sind Kontaktelemente 27a angeordnet, die als Busleiterkontakte dienen. Sie können in verschiedenen Gruppen und in verschiedenen Ausgestaltungen, beispielsweise als Federkontakte oder als Schneidkontakte ausgebildet sein. Die unterschiedlichen Gruppen dienen der Übertragung von Daten und/oder Versorgungsstrom von einem Funktionsmodul 1 zu einem nächsten angereihten weiteren Funktionsmodul 1 und in die jeweils integrierte Elektronikeinheit mit Leiterkarte 3. Zur mechanischen Verbindung von zwei angereihten Funktionsmodulen 1 dienen Rasthaken 24, die in der linken Teilfigur von Fig. 1 zu sehen sind.

Die Leiterkarte 3 wird in eine Leiterkartenaufnahme eingesteckt, die in der Gehäusebasis 25 ausgebildet ist. Diese Leiterkartenaufnahme umfasst in dem dargestellten Ausführungsbeispiel einen Leiterkartenrandverbinder mit weiteren Kontaktelementen 27b, die Leiterkartenrandkontakte 32 der Leiterkarte 3, die an einer ersten Kante 31 ausgebildet sind, kontaktieren. Die weiteren Kontaktelemente 27b sind in den Figuren nicht zu erkennen, durch die Bezugszeichen 27b wird lediglich ihre Position innerhalb der Gehäusebasis 25 angedeutet.

Von den Leiterkartenrandkontakten 32 wird über die weiteren Kontaktelemente 27a innerhalb der Gehäusebasis 25 eine Verbindung zu den seitlich an der Gehäusebasis 25 ausgebildeten und als Busleiterkontakte dienenden Kontaktelementen 27a hergestellt. In alternativen Ausgestaltungen können andere Steckverbinder anstelle des Leiterkartenrandverbinders bzw. der Leiterkartenrandkontakte 32 zur Kontaktierung der Leiterkarte 3 eingesetzt werden.

Im zusammengesetzten Zustand des Funktionsmoduls 1 ist die Leiterkarte 3 in die Leiterkartenaufnahme eingesteckt und wird seitlich von zwei Gehäusedeckeln 28 umschlossen. Das aus Gehäuseseiten 26 und Gehäusedeckeln 28 gebildete Gehäuse ist nach oben hin von einem Anschlussrahmen 4 komplettiert. Die Bezeichnung "oben" bezieht sich auf die in den Figuren gewählte Darstellung. Bei einer in einem Schaltschrank angeordneten Tragschiene weist der Anschlussrahmen 4 in der Regel nach vorne zu der Seite des Schaltschranks hin, die durch eine Tür zugänglich ist.

Der Anschlussrahmen 4 ist an einer Seite über ein Scharnier 41 an einem freien Ende einer der Gehäuseseiten 26 angelenkt. An der gegenüber liegenden Seite ist ein Rastverschluss 42 vorgesehen, der den Anschlussrahmen 4 in der geschlossenen Stellung hält und der geöffnet werden kann, um den Anschlussrahmen 4 aufzuschwenken. Die geschlossene Stellung des Anschlussrahmens 4 ist in Fig. 1 gezeigt. In den Fig. 2 und 3 ist die aufgeschwenkte Stellung des Anschlussrahmens 4 wiedergegeben.

Nach Aufschwenken des Anschlussrahmens 4 kann über einen Hebel 29 die Elektronikeinheit, die Leiterkarte 3 und Gehäusedeckel 28 umfasst, aus der Gehäusebasis 25 entnommen werden und ggf. gegen eine andere Einheit getauscht werden. Auch ist es möglich, die die Leiterkarte 3 teilweise umschließenden Gehäusedeckel 28 zu öffnen. Die Leiterkarte 3 kann dann ausgetauscht werden und zusammen mit den Gehäusedeckeln 28 und dem Hebel 29 wieder zurück in die Gehäusebasis 25 eingesetzt werden. Nach Schließen des Anschlussrahmens 4 ist das Funktionsmodul 1 wieder einsatzbereit. Soweit es die Elektronik des Funktionsmoduls 1 zulässt, kann dieses "hot-swap"-fähig ausgebildet sein, d.h. dass die Leiterkarte 3 getauscht werden kann, ohne dass eine Stromversorgung des Funktionsmoduls 1 bzw. der gesamten Anordnung, in der das Funktionsmodul 1 eingesetzt ist, abgeschaltet werden muss.

Auf einer oder beiden Bestückungsfläche 33 der Leiterkarte 3 können elektronische Bauelemente angeordnet sein, und auch, wie beispielhaft in der Fig. 4 zu sehen ist, ein Steckverbinder, über den eine parallel zur Leiterkarte 3 ausgerichtete Zusatzleiterkarte 34 eingesteckt ist. Die Zusatzleiterkarte(n) 34 können z.B. als Funkmodul, z.B. für den 5G Mobilfunkstandard, als Speicherkarte und/oder Safety-Modul ausgeprägt sein.

Der Anschlussrahmen 4 weist Einschubschächte 43, vorliegend zwei Einschubschächte 43 auf, in denen Anschlussmodule 5 angeordnet sind. Die Anschlussmodule 5, die in der Explosionsdarstellung der Fig. 4 gut zu sehen sind, weisen an einer nach außen zeigenden Oberseite Anschlüsse 51 auf, an denen eine Feldverdrahtung angeschlossen werden kann. Die Anschlüsse 51 können Push-In Anschlüsse sein, Schraubanschlüsse, IDC-Anschlüsse oder Steckverbinder mit verschiedenen Steckkontakt-Ausprägungen und in unterschiedlichen Querschnittsgrößen und unterschiedlicher Anschlussanzahl ausgestaltet sein. Jede beliebige Verbindungsform für elektrische Anschlüsse kann eingesetzt werden.

An der gegenüberliegenden unteren Seite (wiederum auf die Ausrichtung der Figuren bezogen) ist ein Verbinder 52, in diesem Ausführungsbeispiel ein Leiterkartenrandverbinder, ausgebildet, der mit den Anschlüssen 51 elektrisch kontaktiert. Mit dem Leiterkartenrandverbinder wird beim Zuschwenken des Anschlussrahmens 4 und/oder beim Einsetzen des Anschlussmoduls 5 ein elektrischer Kontakt zwischen dem Anschlussmodul 5 und der Leiterkarte 3 etabliert.

Die Leiterkarte 3 weist an ihrer der ersten Kante 31 gegenüberliegenden zweiten Kante 35 in einem ersten Abschnitt 35a dazu Kontaktelemente 36 auf, mit denen der als Leiterkartenrandverbinder ausgebildete Verbinder 52 dann kontaktiert. Die Kontaktelemente 36 sind in diesem Ausführungsbeispiel als entsprechende Leiterkartenrandkontakte ausgebildet.

Die Leiterkarte 3 ist an der genannten zweiten Kante 35 gestuft ausgebildet, so dass es neben dem ersten Abschnitt 35a, in dem sich die als Leiterkartenrandkontakte ausgebildeten Kontaktelemente 36 befinden, einen zweiten Abschnitt 35b gibt, der wie der Abschnitt 35a parallel zur ersten Kante 31 verläuft, wobei jedoch der Abstand von der ersten Kante 31 zur zweiten Kante 35 im Abschnitt 35b größer ist als im Abschnitt 35a. Mit anderen Worten ragt die Leiterkarte 3 im Abschnitt 35b bis näher an den Anschlussrahmen 4 heran bzw. in diesen hinein als im Abschnitt 35a. Dadurch können im Abschnitt 35b Anschlusselemente 37 unmittelbar auf die Leiterkarte 3 montiert, bevorzugt gelötet werden, die durch entsprechende Öffnungen 44 des Anschlussrahmens 4 unmittelbar zugänglich sind. Wie in Fig. 1 ersichtlich ist, können solche Anschlusselemente 37 aus dem Anschlussrahmen 4 hervorstehen oder auch bündig mit dem Anschlussrahmen 4 abschließen oder leicht unterhalb des Anschlussrahmens 4 angeordnet sein, wobei sie jedoch noch bei geschlossenem Anschlussrahmen 4 zugänglich sind.

Im ersten Ausführungsbeispiel sind Anschlusselemente 37, die durch den Anschlussrahmen 4 ragen und über diesen hervorstehen beispielhaft SMA-Antennenanschlüsse mit einem äußeren Schraubgewinde. Diese Anschlusselemente 37 können aber auch als SMP-Antennenanschluss mit einem Steckgesicht und mit dem Anschlussrahmen bündig abschließend ausgeprägt sein. Anschlusselemente 37, die bündig oder leicht unterhalb des Anschlussrahmens 4 liegen, sind hier beispielsweise Datenanschlüsse wie ein USB-C Anschluss oder ein Single-Pair Ethernetanschluss oder ein Busanschluss mit einem Adernpaar und ggf. weiteren Daten- und/oder Energiekontakten oder auch ein Einschubschacht für eine Speicherkarte, insbesondere eine microSD-Karte.

Bevorzugt werden solche Anschlusselemente 37 fest auf der Leiterkarte 3 angeordnet, die mit Signalen mit hohen Frequenzen (Antennenanschlüsse) oder Daten mit hohen Datenraten (USB-C-Anschluss, Single-Pair Ethernetanschluss, microSD-Kartenslot) einsetzbar sind. Es kann so eine hohe Anordnungsdichte dieser Anschlusselemente 37 erreicht werden bei gleichzeitig den Frequenzen bzw. Datenraten angemessener Führung des Signalwegs auf der Leiterkarte 3.

Über die Anschlussmodule 5 können dagegen gut solche Signale und Daten übertragen werden, die mit weniger hohen Frequenzen bzw. Datenraten beaufschlagt sind, bei denen jedoch eine große Flexibilität bei der Art der Verdrahtung gewünscht ist. Beispielsweise können diese Signale von Sensoren oder zu Aktoren sein, die je nach Aufbau der industriellen Automatisierungsanlage entweder über Stecker oder über eine Einzelleiterverbindung an das Funktionsmodul 1 angeschlossen sind. Auch können über die Anschlussmodule als Bus-Steckverbinder Daten von RS-232- oder RS-485-basierten Schnittstellen wie Profibus, CAN, Modbus RTU und dergleichen als unterlagerter Subbus zu einfachen Geräten oder auszulesenden Geräten für z.B. IIoT-Anwendungen übertragen werden. Bei diesen Verbindungen ist der zwischengeschaltete Verbinder 52 aus elektrisch bzw. signaltechnischer Sicht nicht störend, wohingegen der Vorteil, bei einem Wechsel der Leiterkarte 3 diese Verbindung nicht zu trennen und neu belegen zu müssen, gerade bei einer Einzeldrahtverdrahtung immens ist.

Es ist auch denkbar, dass auf der Leiterkarte 3 der Abschnitt 35a z.B. durch den Entfall der beiden als Single-Pair Ethernetanschlüsse ausgebildeten Anschlusselemente 37 und des unteren, als Antennenanschluss ausgebildeten Anschlusselements 37 vergrößert wird und stattdessen weitere Anschlussmodule 5 als Bus-Steckverbinder integriert werden, um z.B. ein Funktionsmodul 1 ausschließlich mit Feldbussen auszubilden. Die Anzahl von zwei Anschlussmodulen 5 im gezeigten Ausführungsbeispiel ist insofern rein beispielhaft.

In den Fig. 5 und 6 ist in gleicher Darstellungsweise wie in den Fig. 1 und 2 ein zweites Ausführungsbeispiel eines anmeldungsgemäßen Funktionsmoduls 1 gezeigt. Gleiche Bezugszeichen kennzeichnen in diesen beiden Figuren gleiche oder gleichwirkende Elemente wie beim ersten Ausführungsbeispiel.

Vom Grundaufbau her ist das Funktionsmodul 1 des zweiten Ausführungsbeispiels analog zu dem des ersten Ausführungsbeispiels aufgebaut mit dem Unterschied, dass die Montagebasis 2 sowie der Anschlussrahmen 4 und damit das gesamte Funktionsmodul 1 eine doppelte Breite von zwei Baueinheiten aufweist.

Um im Produktionsprozess des Funktionsmoduls 1 möglichst viele Komponenten mehrfach für verschiedene Ausgestaltungen des Funktionsmoduls 1 einsetzen zu können, ist dabei die Montagebasis 2 aus zwei Elementen der Breite einer Baueinheit zusammengesetzt.

Gegenüber dem Funktionsmodul 1 des ersten Ausführungsbeispiels wird der zur Verfügung stehende größere vom Gehäuse umschlossene Bereich genutzt, um zwei Leiterkarten 3 und 3` parallel zueinander anzuordnen. Beide Leiterkarten 3, 3' sind in die Montagebasis 2 eingesteckt und somit mit den als Busleiterkontakte ausgebildeten weiteren Kontaktelementen 27b gekoppelt. Die Anzahl von zwei Leiterkarten 3, 3' ist dabei rein beispielhaft, es kann auch eine größere Anzahl an Leiterkarten 3, 3' vorgesehen sein. Die Leiterkarten 3, 3' können zudem über Board-to-Board-Steckverbinder miteinander verbunden sein. In alternativen Ausgestaltungen kann vorgesehen sein, dass nicht jede der Leiterkarten 3, 3' in die Montagebasis 2 eingesteckt ist und/oder an die Busleiterkontakte angebunden ist.

Beim dargestellten Beispiel ist die in den Figuren vordere Leiterkarte 3 dabei genau wie die Leiterkarte 3 des ersten Ausführungsbeispiels als gestufte Leiterkarte mit unterschiedlich ausgebildeten Abschnitten 35a, b ausgebildet, wobei im Anschlussrahmen 4 eingesetzte Anschlussmodule 5 die Leiterkarte 3 im Abschnitt 35a kontaktieren. Der höhere (in der Darstellung der Fig. 6) Abschnitt 35b nimmt die unmittelbar zugänglichen Anschlusselemente 37 auf.

Die parallel dazu angeordnete Leiterkarte 3' ist in diesem Ausführungsbeispiel ebenfalls als gestufte Leiterkarte ausgebildet, wobei ein verglichen zum Abschnitt 35a der Leiterkarte 3 schmalerer Abschnitt 35a an der in der Figur linken Seite der Leiterkarte ausgebildet ist und mit einem Anschlussmodul 5 im Anschlussrahmen 4 zusammenwirkt. Das Anschlussmodul 5 kann z.B. auch als Single-Pair Ethernetanschluss mit zwei Versorgungsleitungen verwendet werden. Beim gezeigten Beispiel sind in dem Abschnitt 35b der Leiterkarte 3' drei Single-Pair Ethernetbuchsen ggf. mit Power over Data Lines (PoDL) sowie zwei klassische RJ45 Ethernetbuchsen angeordnet.

Es ist jedoch auch denkbar, dass die Leiterkarte 3' ihren Abschnitt 35b in gleicher Breite und in gleicher Position aufweist wie die Leiterkarte 3. In einer weiteren Ausgestaltung ist auch möglich, dass nur eine der Leiterkarten 3, 3' gestuft ausgebildet ist und die andere(n) der Leiterkarten entweder nur einen durchgängig hohen Abschnitt 35b aufweist bzw. aufweisen oder nur einen durchgängig abgesenkten Abschnitt 35a, der für den Einsatz einer Mehrzahl von Anschlussmodulen 5 vorgesehen ist.

In weiteren Ausgestaltungen ist in analoger Weise auch der Aufbau eines Funktionsmoduls 1 mit einer noch breiteren Baubreite als zwei Baueinheiten denkbar, die entsprechend drei oder mehr Leiterkarten 3 bzw. 3' aufweist.

Grundsätzlich braucht die Anzahl der Baueinheiten und der Leiterkarten 3, 3' unabhängig von der Anzahl vorhandener Leiterkarten 3, 3' nicht unbedingt übereinstimmen. Beispielsweise kann auch für eine oder mehrere der Leiterkarten 3, 3' ein größerer Freiraum im Inneren des Funktionsmoduls 1 bereitgestellt werden, z.B. wenn Bauraum für größere Bauelemente wie z.B. Kühlkörper oder zur Konvektion bzw. Wärmeabführung benötigt wird.

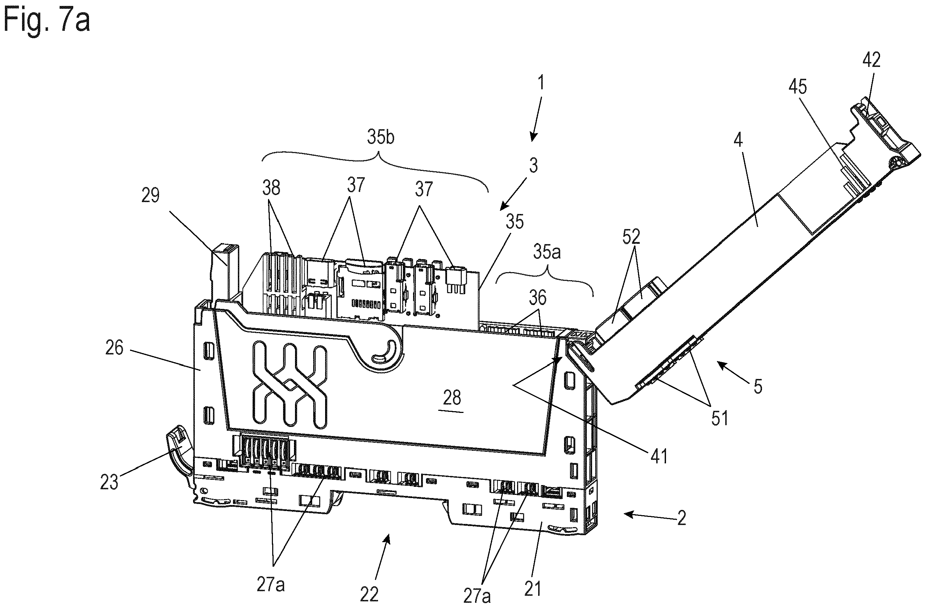

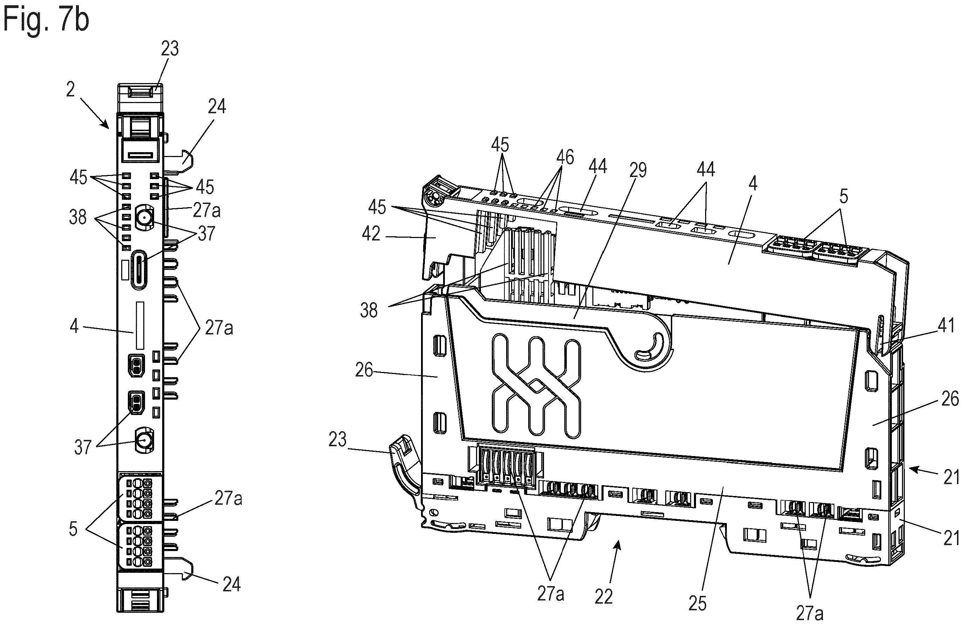

In den Fig. 7a und b ist in gleicher Darstellungsweise wie in den Fig. 1 und 2 ein drittes Ausführungsbeispiel eines anmeldungsgemäßen Funktionsmoduls 1 gezeigt. Gleiche Bezugszeichen kennzeichnen in dieser Figur gleiche oder gleichwirkende Elemente wie bei den zuvor beschriebenen Ausführungsbeispielen.

Der Grundaufbau das Funktionsmoduls 1 entspricht auch hier dem der ersten beiden Ausführungsbeispiele, auf deren Beschreibung hiermit explizit verwiesen wird.

Zusätzlich zu den Anschlusselementen 37 sind beim Beispiel der Fig. 7 in dem Bereich des zweiten Abschnitts 35b der Leiterkarte 3 Lichtleitelemente 38 und weitere Lichtleitelemente 45 vorgesehen, denen Signal-LEDs auf der Leiterkarte 3 zugeordnet sind. Die Lichtleitelement 38 und die weiteren Lichtleitelemente 45 sind im dargestellten Beispiel als Lichtleitstifte ausgebildet. Dabei sind die Lichtleitelemente 38 an der Leiterkarte 3 und die weiteren Lichtleitelemente 45 im Anschlussrahmen 4 montiert bzw. festgelegt. Bei zugeklapptem Anschlussrahmen 4 sind Stirnflächen der weiteren Lichtleitelemente 45 grundsätzlich und die Lichtleitelemente 38 durch entsprechende Öffnungen 46 des Anschlussrahmens 4 sichtbar.

Die Kombination der fest integrierten Lichtleitelemente 38 und der abschwenkbaren weiteren Lichtleitelemente 45 ist vorteilhaft, weil so beim Abschwenken des Anschlussrahmens 4 eine Kollision zwischen Lichtleitelementen und Anschlusselementen vermieden werden kann. Zudem kann die Anzahl der Lichtleitelemente 38, 45 mit Signal-LEDs erhöht werden. Eine größere Anzahl von Signal-LEDs wird beispielsweise zur Anzeige der Stärke eines Funksignals benötigt.

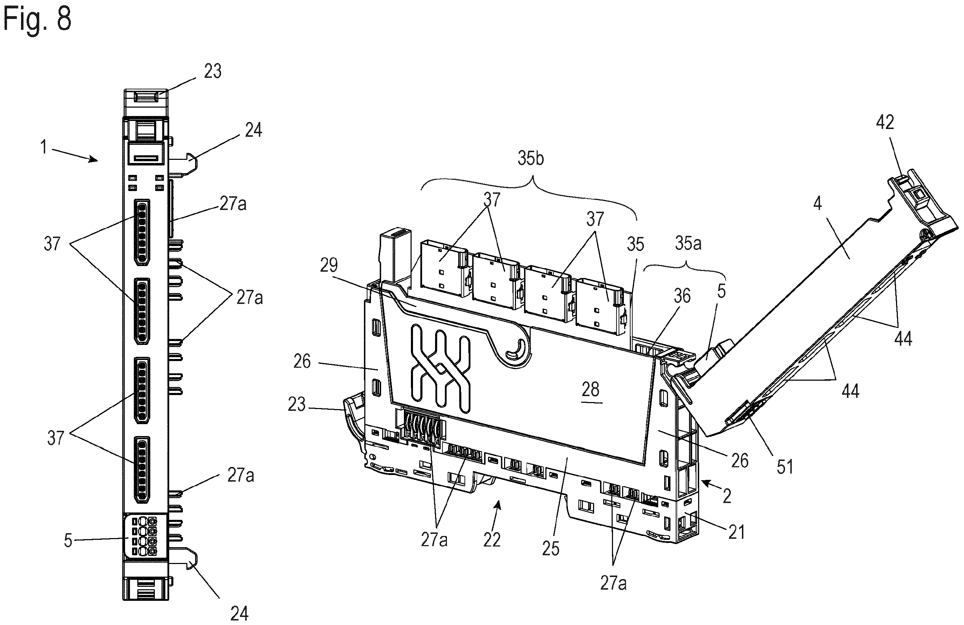

In Fig. 8 ist wiederum in gleicher Darstellungsweise wie in den Fig. 1 und 2 ein viertes Ausführungsbeispiel eines anmeldungsgemäßen Funktionsmoduls 1 gezeigt. Gleiche Bezugszeichen kennzeichnen gleiche oder gleichwirkende Elemente wie bei den zuvor beschriebenen Ausführungsbeispielen. Auf der linken Seite der Fig. 8 ist eine Frontansicht und auf der rechten Seite eine isometrische Schrägansicht des Funktionsmoduls 1 wiedergegeben.

Das Funktionsmodul 1 ist hier als Ein- und/oder Ausgabemodul (I/O-Modul) einer industriellen Automatisierungsanlage ausgebildet. Es weist neben einem Anschlussmodul 5 vier Anschlusselemente 37 auf, die jeweils beispielhaft als 8-polige, geschirmte Sensor-/Aktor-Steckverbinder ausgebildet sind. Das Funktionsmodul 1 eignet sich damit z.B. gut für die Fertigungsmesstechnik und Fertigungsprüftechnik weil die Module trotz sehr guter Schirmung in Relation zu Rundsteckverbindern und Push-In-Anschlüssen seht platzsparend bzgl. der Baubreite und Höhe aufgebaut werden können und über das Anschlussmodul 5 ein Sensorfunktionssignal auf einen Aktor oder ein Alarmsignal bei einer Schwellwertüberschreitung ausgegeben und/oder auch nur das I/O-Modul je nach Stationsarchitektur und -aufbau gesondert versorgt werden kann.

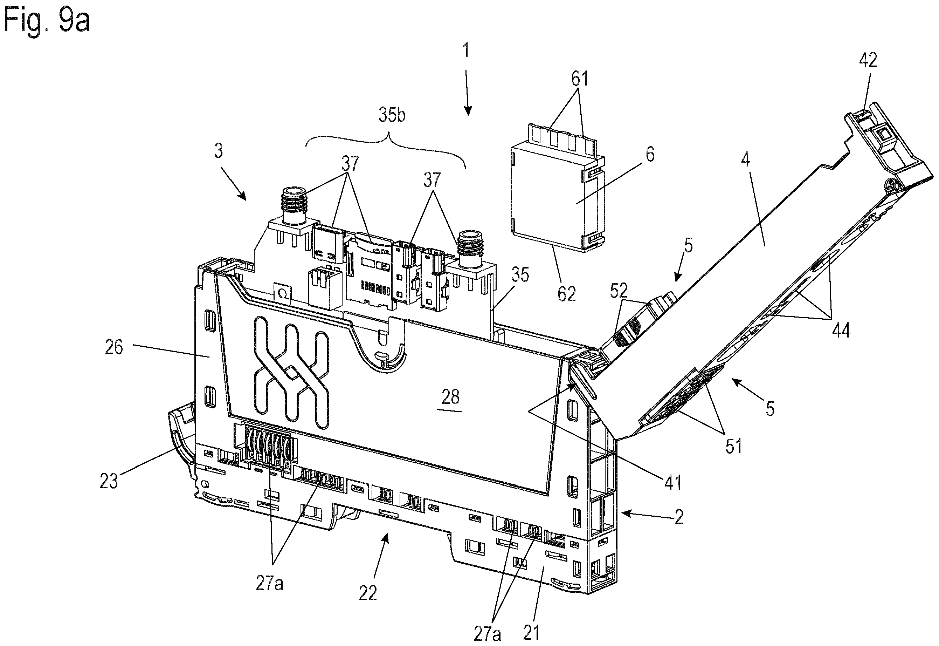

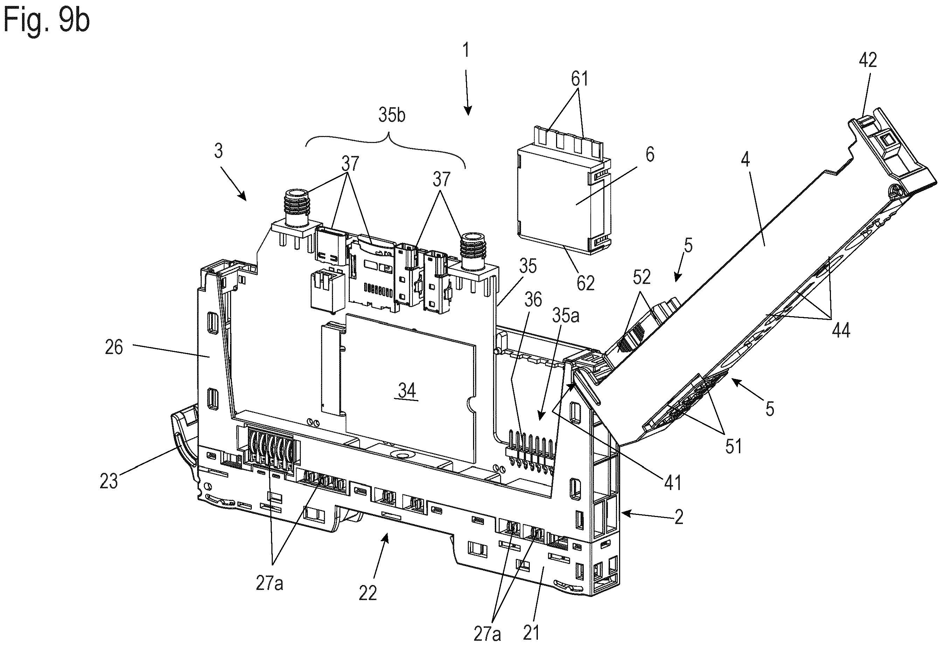

In den Fig. 9a und 9b ist wiederum in gleicher Darstellungsweise wie in den Fig. 1 und 2 ein fünftes Ausführungsbeispiel eines anmeldungsgemäßen Funktionsmoduls 1 gezeigt. Gleiche Bezugszeichen kennzeichnen auch in diesen beiden Figuren gleiche oder gleichwirkende Elemente wie bei den zuvor beschriebenen Ausführungsbeispielen.

Im Unterschied zu den zuvor beschriebenen Ausführungsbeispielen kontaktiert bei dem Beispiel der Figuren 9a, b das Anschlussmodul 5 die Leiterkarte 3 nicht unmittelbar. Stattdessen ist ein einschiebbares Steckmodul 6, das Platz für zusätzliche Elektronikelemente bereitstellt, zwischengeschaltet. Die Figuren 9a, b zeigen das Steckmodul vor dem Einschieben bzw. Einstecken in das Funktionsmodul 1. In der Figur 9b ist einer der Gehäusedeckel 28 entfernt, um einen Blick auf die Leiterkarte 3 und den für das Steckmodul 6 zur Verfügung stehenden Platz zu gewähren.

Das Steckmodul 6 weist an einer oberen Seite Leiterkartenrandkontakte 61 auf, die der wiederum als Leiterkartenrandverbinder ausgebildete Verbinder 52 des Anschlussmoduls 5 kontaktiert. An seiner unteren, in Einsteckrichtung voraneilenden Seite ist ein Steckverbinder 62 angeordnet, der die Kontaktelemente 36 der Leiterkarte 3 kontaktiert. Der Steckverbinder 62 selbst ist in der Figur nicht zu erkennen, durch das Bezugszeichen 62 wird lediglich seine Position am Steckmodul 6 angedeutet.

Die Kontaktelemente 36 der Leiterkarte 3 sind im dargestellten Beispiel als Stiftkontakte einer Stiftleiste ausgebildet. Alternativ könnten als Kontaktelemente 36 wie in den vorherigen Ausführungsbeispielen auch Leiterkartenrandkontakte vorgesehen sein. Der Steckverbinder 62 am Steckmodul 6 ist entsprechend der gewählten Kontaktart ausgebildet.

Die Leiterkarte 3 ist auch hier gestuft ausgestaltet, wobei die Stufenhöhe entsprechend um die Einbauhöhe des Steckmoduls 6 gegenüber den vorherigen Ausführungsbeispielen vergrößert ist. Die Leiterkartenrandkontakte 61 des Steckmoduls 6 befinden sich bevorzugt bei eingestecktem Steckmodul 6 an derselben Position, an der sich die Leiterkartenrandkontakte der Leiterkarte 3 bei den zuvor beschriebenen Ausführungsbeispielen befinden. Dadurch können Anschlussmodule 5 für beide Ausgestaltungen eines Funktionsmoduls 1 verwendet werden.

Das Steckmodul 6 kann z.B. elektronische Schaltungen zur Signalanpassung der über das Anschlussmodul 5 ausgegebenen oder empfangenen Signale oder Daten aufweisen.

### Bezugszeichen

- 1: Funktionsmodul
- 2: Montagebasis
- 21: Rastsockel
- 22: Tragschienenaufnahme
- 23: Lösehebel
- 24: Rasthaken
- 25: Gehäusebasis
- 26: Gehäuseseite
- 27a: Kontaktelement
- 27b: weiteres Kontaktelement
- 28: Gehäusedeckel
- 29: Hebel
- 3: Leiterkarte
- 31: erste Kante
- 32: Leiterkartenrandkontakt
- 33: Bestückungsfläche
- 34: Zusatzleiterkarte
- 35: zweite Kante
- 35a, b: Abschnitt
- 36: Kontaktelement
- 37: Anschlusselement
- 38: Lichtleitelement
- 4: Anschlussrahmen
- 41: Scharnier
- 42: Rastverschluss
- 43: Einschubschacht
- 44: Öffnung
- 45: Lichtleitelement
- 46: Öffnung für Lichtleitelement
- 5: Anschlussmodul
- 51: Anschluss
- 52: Verbinder
- 6: Steckmodul
- 61: Leiterkartenrandkontakt
- 62: Steckverbinder

## Patentansprüche

1. Busfähiges aneinanderreihbares Funktionsmodul (1) zur Steuerung und/oder Überwachung technischer Prozesse aufweisend
- eine Montagebasis (2) mit Rastmitteln zum Befestigen auf einer Tragschiene mit wenigstens einem seitlichen Busleiterkontakt, sowie einem Steckverbinder, der mit dem Busleiterkontakt verbunden ist;
- eine entlang einer ersten Kante (31) in den Steckverbinder eingesteckte Leiterkarte (3), die an einer der ersten parallelen zweiten Kante (35) Kontaktelemente (36) aufweist;
- einen schwenkbar an der Montagebasis (2) angelenkten Anschlussrahmen (4), der in einer zugeschwenkten Position die Leiterkarte (3) entlang ihrer zweiten Kante (35) übergreift und der mindestens einen Einschubschacht (43) bereitstellt;
- mindestens ein Anschlussmodul (5), das in den mindestens einen Einschubschacht (43) eingesetzt ist und an einer zugänglichen Oberseite Anschlüsse (51) bereitstellt und an einer gegenüberliegenden Unterseite einen Verbinder (52) aufweist, der in einer zugeschwenkten Position des Anschlussrahmens (4) auf die Leiterkarte (3) aufgesteckt ist und deren Kontaktelemente (36) kontaktiert;
**dadurch gekennzeichnet, dass**
- die Leiterkarte (3) entlang ihrer zweiten Kante (35) gestuft ausgebildet ist, wodurch mindestens zwei Abschnitte (35a, 35b) gebildet sind, in denen die Leiterkarte (3) unterschiedlich weit in Richtung des Anschlussrahmens (4) ragt, wobei
- sich in einem ersten Abschnitt (35a) die Kontaktelemente (36) für den Verbinder (52) des mindestens einen Anschlussmoduls (5) befinden, und wobei
- die Leiterkarte (3) in einem zweiten Abschnitt (35b) mindestens ein Anschlusselement (37) aufweist, das durch eine Öffnung (44) im Anschlussrahmen (4) unmittelbar zugänglich ist.

2. Funktionsmodul (1) nach Anspruch 1, bei dem der Verbinder (52) ein Leiterkartenrandverbinder ist, wobei die Kontaktelemente (36) Leiterkartenrandkontakte sind, die entlang des Leiterkartenrands in dem ersten Abschnitt (35a) ausgebildet sind.

3. Funktionsmodul (1) nach Anspruch 1, bei dem die Kontaktelemente (36) Kontakte eines Steckverbinders, insbesondere einer Buchsenleiste oder Stiftleiste, sind, der im Bereich des Leiterkartenrands in dem ersten Abschnitt (35a) angeordnet ist.

4. Funktionsmodul (1) nach einem der Ansprüche 1 bis 3, bei dem das mindestens eine Anschlusselement (37) ein Steckverbinder ist.

5. Funktionsmodul (1) nach Anspruch 4, bei dem das mindestens eine Anschlusselement (37) ein Steckverbinder zur Datenübertragung ist, insbesondere ein USB-C und/oder RJ-45 und/oder Single-Pair Ethernet Steckverbinder.

6. Funktionsmodul (1) nach einem der Ansprüche 1 bis 5, bei dem das mindestens eine Anschlusselement (37) ein Schraubverbinder und/oder ein Steckverbinder für HF-Signale ist.

7. Funktionsmodul (1) nach einem der Ansprüche 1 bis 6, bei dem das mindestens eine Anschlusselement (37) eine Aufnahme für eine steckbare Speicherkarte ist

8. Funktionsmodul (1) nach einem der Ansprüche 1 bis 7, bei dem die Anschlüsse (51) der Anschlussmodule (5) Einzelleiter-Anschlüsse sind.

9. Funktionsmodul (1) nach Anspruch 8, bei dem die Anschlüsse (51) der Anschlussmodule (5) Push-In Anschlüsse oder Schraubanschlüsse oder IDC-Anschlüssen oder Steckverbinder mit verschiedenen Steckkontakt-Ausprägungen sind.

10. Funktionsmodul (1) nach einem der Ansprüche 1 bis 9, bei dem die Leiterkarte (3) an ihrer ersten Kante (31) Leiterkartenrandkontakte (32) aufweist und bei dem der Steckverbinder der Montagebasis (2) ein Leiterkartenrandverbinder ist.

11. Funktionsmodul (1) nach einem der Ansprüche 1 bis 10, bei dem die Leiterkarte (3) eine parallel zu dieser angeordnete Zusatzleiterkarte (34) trägt.

12. Funktionsmodul (1) nach einem der Ansprüche 1 bis 11, aufweisend mindestens zwei parallel zueinander angeordnete Leiterkarten (3, 3'), von denen mindestens eine mit einer ersten Kante (31) in einen Steckverbinder der Montagebasis (2) eingesteckt ist, und wobei mindestens eine der Leiterkarten (3, 3') gestuft ausgebildet ist.

13. Funktionsmodul (1) nach Anspruch 12, bei dem die Leiterkarten (3, 3') untereinander mit einem Board-to-Board-Steckverbinder verbunden sind.

14. Funktionsmodul (1) nach einem der Ansprüche 1 bis 13, bei dem das mindestens eine Anschlussmodul (5) indirekt über ein zwischengestecktes Steckmodul (6) mit den Kontaktelementen (36) verbunden ist.

15. Funktionsmodul (1) nach einem der Ansprüche 1 bis 14, ausgebildet als Feldbuskoppler, als Steuerungsrechner und/oder als Ein- und Ausgabemodul.

## Claims

1. Bus-capable function module (1) which can be connected in series for controlling and/or monitoring technical processes, comprising
- a mounting base (2) having latching means for fastening onto a mounting rail with at least one lateral bus line contact, as well as a plug connector which is connected to the bus line contact;
- a printed circuit board (3) inserted into the plug connector along a first edge (31) and having contact elements (36) on a second edge (35) parallel to the first edge;
- a connection frame (4) which is pivotably hinged to the mounting base (2) and which in a pivoted closed position engages over the printed circuit board (3) along its second edge (35) and which provides at least one insertion slot (43);
- at least one connection module (5), which is inserted into the at least one insertion slot (43) and provides connections (51) on an accessible upper side and has a connector (52) on an opposite lower side, which connector is plugged onto the printed circuit board (3) in a pivoted closed position of the connection frame (4) and contacts the contact elements (36) thereof;
**characterized in that**
- the printed circuit board (3) is of stepped design along its second edge (35), whereby at least two sections (35a, 35b) are formed in which the printed circuit board (3) projects differently far in the direction of the connection frame (4), wherein
- the contact elements (36) for the connector (52) of the at least one connection module (5) are located in a first section (35a), and wherein
- the printed circuit board (3) has at least one connection element (37) in a second section (35b), which is directly accessible through an opening (44) in the connection frame (4).

2. Function module (1) according to claim 1, in which the connector (52) is a printed circuit board edge connector, wherein the contact elements (36) are printed circuit board edge contacts which are formed along the printed circuit board edge in the first section (35a).

3. Function module (1) according to claim 1, in which the contact elements (36) are contacts of a plug connector, in particular a socket connector or pin header, which is arranged in the region of the printed circuit board edge in the first section (35a).

4. Function module (1) according to one of claims 1 to 3, in which the at least one connection element (37) is a plug connector.

5. Function module (1) according to claim 4, in which the at least one connection element (37) is a plug connector for data transmission, in particular a USB-C and/or RJ-45 and/or single-pair Ethernet plug connector.

6. Function module (1) according to one of claims 1 to 5, in which the at least one connection element (37) is a screw connector and/or a plug connector for RF signals.

7. Function module (1) according to one of claims 1 to 6, in which the at least one connection element (37) is a receptacle for a pluggable memory card.

8. Function module (1) according to one of claims 1 to 7, wherein the connections (51) of the connection modules (5) are single-wire connections.

9. Function module (1) according to claim 8, in which the connections (51) of the connection modules (5) are push-in connections or screw connections or IDC connections or plug connectors with different plug contact characteristics.

10. Function module (1) according to one of claims 1 to 9, in which the printed circuit board (3) has printed circuit board edge contacts (32) on its first edge (31) and in which the plug connector of the mounting base (2) is a printed circuit board edge connector.

11. Function module (1) according to one of claims 1 to 10, in which the printed circuit board (3) carries an additional printed circuit board (34) arranged parallel thereto.

12. Function module (1) according to one of claims 1 to 11, comprising at least two printed circuit boards (3, 3') arranged parallel to each other, of which at least one is inserted with a first edge (31) into a plug connector of the mounting base (2), and wherein at least one of the printed circuit boards (3, 3') is of stepped design.

13. Function module (1) according to claim 12, in which the printed circuit boards (3, 3') are connected to one another by a board-to-board plug connector.

14. Function module (1) according to one of claims 1 to 13, in which the at least one connection module (5) is indirectly connected to the contact elements (36) via an interposed plug-in module (6).

15. Function module (1) according to one of claims 1 to 14, designed as a fieldbus coupler, as a control computer and/or as an input and output module.

## Revendications

1. Module fonctionnel (1) connectable à un bus et pouvant être monté en série pour la commande et/ou la surveillance de processus techniques, comportant
- une embase de montage (2) avec des moyens d'enclenchement pour la fixation sur un rail de support avec au moins un contact de conducteur de bus latéral et avec un connecteur enfichable qui est connecté au contact de conducteur de bus ;
- une carte de circuits (3) enfichée le long d'une première arête (31) dans le connecteur enfichable, qui présente des éléments de contact (36) sur une deuxième arête (35) parallèle à la première ;
- un cadre de raccordement (4) articulé de façon pivotante sur l'embase de montage (2), qui entoure la carte de circuits (3) le long de sa deuxième arête (35) dans une position rabattue et produit l'au moins une gaine d'insertion (43) ;
- au moins un module de raccordement (5) qui est inséré dans l'au moins une gaine d'insertion (43) et offre des raccords (51) sur une face supérieure accessible et comporte sur une face inférieure opposée un connecteur (52) qui est enfiché sur la carte de circuits (3) dans une position rabattue du cadre de raccordement (4) et vient en contact avec les éléments de contact (36) de celle-ci ;
**caractérisé en ce que**
- la carte de circuits (3) est conformée en gradins le long de sa deuxième arête (35), de sorte que sont formées au moins deux parties (35a, 35b) dans lesquelles la carte de circuits (3) dépasse plus ou moins loin en direction du cadre de raccordement (4),
- les éléments de contact (36) pour le connecteur (52) de l'au moins un module de raccordement (5) se trouvant dans une première partie (35a) et
- la carte de circuits (3) comportant dans une deuxième partie (35b) au moins un élément de raccordement (37) qui est directement accessible à travers une ouverture (44) du cadre de raccordement (4).

2. Module fonctionnel (1) selon la revendication 1, dans lequel le connecteur (52) est un connecteur de bord de carte de circuits, les éléments de contact (36) étant des contacts de bord de carte de circuits qui sont formés le long du bord de la carte de circuits dans la première partie (35a).

3. Module fonctionnel (1) selon la revendication 1, dans lequel les éléments de contact (36) sont des contacts d'un connecteur enfichable, en particulier d'une barrette femelle ou d'une barrette mâle, qui est disposé dans la région du bord de la carte de circuits dans la première partie (35a).

4. Module fonctionnel (1) selon l'une des revendications 1 à 3, dans lequel l'au moins un élément de raccordement (37) est un connecteur enfichable.

5. Module fonctionnel (1) selon la revendication 4, dans lequel l'au moins un élément de raccordement (37) est un connecteur enfichable pour la transmission de données, en particulier un connecteur enfichable USB-C et/ou RJ-45 et/ou Ethernet à paire simple.

6. Module fonctionnel (1) selon l'une des revendications 1 à 5, dans lequel l'au moins un élément de raccordement (37) est un connecteur fileté et/ou un connecteur enfichable pour signaux HF.

7. Module fonctionnel (1) selon l'une des revendications 1 à 6, dans lequel l'au moins un élément de raccordement (37) est un réceptacle pour une carte de mémoire enfichable.

8. Module fonctionnel (1) selon l'une des revendications 1 à 7, dans lequel les raccords (51) des modules de raccordement (5) sont des raccords monofilaires.

9. Module fonctionnel (1) selon la revendication 8, dans lequel les raccords (51) des modules de raccordement (5) sont des raccords *push-in* ou des raccords filetés ou des raccords IDC ou des connecteurs enfichables avec différentes configurations de contacts enfichables.

10. Module fonctionnel (1) selon l'une des revendications 1 à 9, dans lequel la carte de circuits (3) présente sur sa première arête (31) des contacts de bord de carte de circuits (32) et dans lequel le connecteur enfichable de l'embase de montage (2) est un connecteur de bord de carte de circuits.

11. Module fonctionnel (1) selon l'une des revendications 1 à 10, dans lequel la carte de circuits (3) porte une carte de circuits supplémentaire (34) disposée parallèlement à elle.

12. Module fonctionnel (1) selon l'une des revendications 1 à 11, comportant au moins deux cartes de circuits (3, 3') disposées parallèlement l'une à l'autre, dont l'une au moins est enfichée par une première arête (31) dans un connecteur enfichable de l'embase de montage (2), au moins une des cartes de circuits (3, 3') étant conformée en gradins.

13. Module fonctionnel (1) selon la revendication 12, dans lequel les cartes de circuits (3, 3') sont connectées les unes aux autres avec un connecteur carte à carte enfichable.

14. Module fonctionnel (1) selon l'une des revendications 1 à 13, dans lequel l'au moins un module de raccordement (5) est connecté indirectement aux éléments de contact (36) par l'intermédiaire d'un module enfichable (6) intercalé.

15. Module fonctionnel (1) selon l'une des revendications 1 à 14, conçu comme un coupleur de bus de terrain, comme un calculateur d'unité de commande et/ou comme un module d'entrée et de sortie.
